# FASCICULE DE BREVET EUROPEEN

(11) **EP 2 820 760 B1**
(45) Date de publication et mention de la délivrance du brevet: **03.06.2020**
(21) Numéro de dépôt: 13706007.5
(22) Date de dépôt: 26.02.2013
(51) Int. Cl.: H03M 1/14, H03M 1/12, H03M 1/46, H03M 1/56

(54) **DISPOSITIF DE CONVERSION DE SIGNAUX ANALOGIQUES EN SIGNAUX NUMÉRIQUES**
VORRICHTUNG ZUM UMSETZEN ANALOGER SIGNALE IN DIGITALE SIGNALE
DEVICE FOR CONVERTING ANALOGUE SIGNALS INTO DIGITAL SIGNALS

(30) Priorité: 27.02.2012 FR 1251736
(43) Date de publication de la demande: 07.01.2015
(73) Titulaire: Centre National de la Recherche Scientifique (C.N.R.S.), 75016 Paris (FR)
(72) Inventeur: DZAHINI, Daniel, F-38113 Veurey Voroize (FR); RARBI, Fatah-Ellah, F-74150 Rumilly (FR); GALLIN-MARTEL, Laurent, F-38960 Saint Etienne de Crossey (FR)
(74) Mandataire: Hautier IP
(86) Numéro de dépôt international: PCT/EP2013/053751
(87) Numéro de publication internationale: WO 2013/127751

(56) Documents cités:
- EP-A1- 2 053 748
- US-A- 5 014 056
- US-A1- 2007 279 506
- MARTIJN F SNOEIJ ET AL: "Multiple-Ramp Column-Parallel ADC Architectures for CMOS Image Sensors", IEEE JOURNAL OF SOLID-STATE CIRCUITS, IEEE SERVICE CENTER, PISCATAWAY, NJ, USA, vol. 42, no. 12, 1 December 2007 (2007-12-01), pages 2968-2977, XP011197063, ISSN: 0018-9200, DOI: 10.1109/JSSC.2007.908720
- ANAND T ET AL: "Energy efficient asymmetric binary search switching technique for SAR ADC", ELECTRONIC LET, THE INSTITUTION OF ENGINEERING AND TECHNOLOGY, vol. 46, no. 22, 28 October 2010 (2010-10-28), pages 1487-1488, XP006037061, ISSN: 1350-911X, DOI: 10.1049/EL:20102691

## Description

La présente invention concerne le domaine de la conversion de signaux analogiques en signaux numériques.

En particulier dans le domaine des imageurs, comprenant une matrice de capteurs, les signaux analogiques présents aux extrémités de colonnes de capteurs doivent être convertis en signaux numériques.

Le document US-2007/0279506 décrit un dispositif de conversion mettant en œuvre une conversion à l'aide d'une rampe et une conversion par approximations successives. Ce dispositif ne donne cependant pas satisfaction, notamment du fait de l'usage d'un grand nombre de composants électroniques, de sa lenteur et de l'incertitude en ce qui concerne la correspondance entre le signal analogique d'origine et le signal numérique obtenu.

Dans la mesure où la largeur des colonnes de capteurs tend à se réduire afin d'améliorer la qualité des images, il se pose des difficultés liées à la rapidité des conversions, à la réduction de la consommation en énergie électrique des circuits électroniques employés, à obtention d'une grande résolution, c'est-à-dire à l'obtention d'un nombre élevé de bits des signaux numériques, à l'obtention d'un signal numérique fiable, c'est-à-dire représentant le signal analogique de façon la plus exacte que possible, et à la réduction des surfaces occupées par les circuits électroniques dont la largeur doit être adaptée à la largeur des colonnes de capteurs.

Le but de la présente invention est de proposer une solution à ces difficultés.

Il est proposé un procédé selon la revendication 1 de conversion de signaux analogiques, présents respectivement sur une pluralité de voies, en des signaux numériques.

Ce procédé comprend : générer une succession, commune à toutes les voies, de premiers signaux analogiques prédéterminés présentant des valeurs prédéterminées en escalier à pas successifs larges, formant une rampe ou succession de paliers, dont chaque valeur correspond à des bits de poids forts de signaux numériques.

Pour chaque voie, le procédé comprend : dans une première phase, comparer la valeur du signal analogique à convertir successivement à chacune desdites valeurs prédéterminées de ladite rampe, détecter la première valeur prédéterminée de ladite rampe, issue de la comparaison ci-dessus, succédant à de la valeur du signal analogique à convertir, mémoriser les valeurs des bits de poids forts correspondant à ladite première valeur prédéterminée détectée, mémoriser l'écart ou résidu résultant de la différence entre la valeur du signal analogique à convertir et ladite valeur prédéterminée détectée ; dans une seconde phase, comparer par approximations successives ledit écart ou résidu à des seconds signaux analogiques prédéterminés compris entre deux bornes de seconds signaux analogiques dont l'écart inter-bornes est supérieur audit pas de ladite rampe, mémoriser successivement les états des résultats de la comparaison par approximations successives, correspondant à des bits de poids faibles de signaux numériques.

Puis, pour chaque voie, le procédé comprend : dans une troisième phase, assembler les bits de poids forts et les bits de poids faibles, de façon à délivrer un signal numérique correspondant à la valeur du signal analogique à convertir, ce signal numérique comprenant les bit de poids faibles, à l'exception du plus grand, et les bits de poids forts auxquels est additionné le plus grand des bits de poids faibles, en additionnant le plus grand des bits de poids faibles et le plus petit des bits de poids forts, si bien que le nombre de bits du signal numérique obtenu est égal au nombre de bits de poids forts plus le nombre de bits de poids faibles moins un.

Le procédé peut comprendre : comparer la valeur du signal analogique à convertir successivement à chacune desdites valeurs prédéterminées, dans le sens décroissant, et détecter la première valeur prédéterminée du premier signal analogique inférieure à la valeur du signal analogique à convertir,
Il est également proposé un dispositif selon la revendication 3 de conversion de signaux analogiques, présents respectivement sur une pluralité de voies, en des signaux numériques, pour la mise en œuvre du procédé ci-dessus.

Ce dispositif comprend un circuit générateur commun apte à générer une succession de premiers signaux analogiques prédéterminés présentant des premières valeurs prédéterminées correspondant à des bits de poids forts de signaux numériques.

En outre, ce dispositif comprend, pour chaque voie, un circuit local qui comprend un premier moyen de comparaison, incluant un comparateur unique, pour comparer lesdits premiers signaux analogiques prédéterminés avec le signal analogique à convertir, un premier moyen de mémorisation des bits de poids forts de signaux numériques correspondant à la valeur d'un premier signal analogique prédéterminé succédant à la valeur du signal analogique correspondant à convertir et détectée par ledit premier moyen de comparaison, un moyen de mémorisation de l'écart ou résidu résultant de la différence entre la valeur du signal analogique correspondant à convertir et ladite première valeur prédéterminée détectée, un moyen générateur apte à générer un nombre prédéterminé de seconds signaux analogiques, un second moyen de comparaison, incluant ledit comparateur unique, pour comparer par approximations successives lesdits seconds signaux analogiques avec respectivement ledit écart ou résidu, un second moyen de mémorisation des bits de poids faibles de signaux numériques correspondant aux résultats issus dudit second moyen de comparaison, et un moyen d'assemblage pour assembler lesdits bits de poids forts et lesdits bits de poids faibles, de façon à délivrer un signal numérique correspondant au signal analogique correspondant à convertir.

Le moyen de mémorisation de l'écart ou résidu peut comprendre un condensateur.

Il est également proposé une matrice de capteurs équipée d'un dispositif de conversion, les circuits locaux étant placés aux extrémités des colonnes de cette matrice, sur une ligne à l'extrémité de laquelle est placé le circuit commun.

Un dispositif de conversion selon la présente invention va maintenant être décrit à titre d'exemple non limitatif, illustré sur le dessin sur lequel :
- la figure 1 représente un schéma électronique général du dispositif de conversion ;
- la figure 2 représente un schéma électronique plus détaillé du dispositif de conversion ;
- la figure 3 représente un schéma électronique du dispositif de conversion selon une première configuration de fonctionnement ;
- la figure 4 représente un schéma électronique du dispositif de conversion selon une seconde configuration de fonctionnement ;
- et la figure 5 représente schématiquement un montage du dispositif de conversion.

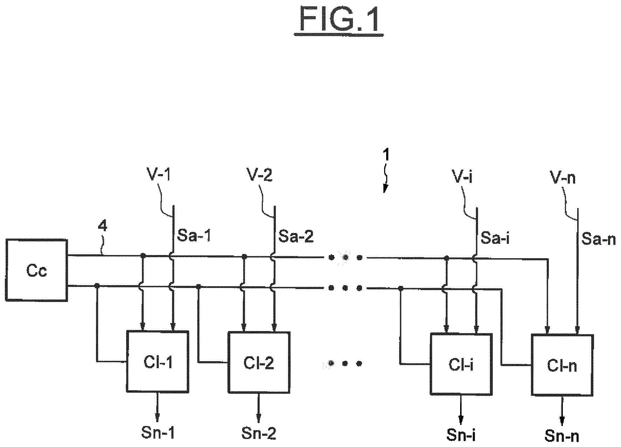

Le dispositif de conversion 1 illustré sur la figure 1 est destiné à la conversion de signaux analogiques Sa-1, Sa-2 ... Sa-i ... Sa-n présents sur une pluralité de voies V-1, V-2 ... V-i ... V-n, qui peuvent par exemple être formées par les connexions terminales de matrices de capteurs, en particulier des capteurs d'images, des capteurs de rayonnements lumineux ou thermiques tels que des bolomètres, des photomultiplicateurs, ou encore des capteurs sensoriels.

Le dispositif de conversion 1 comprend un circuit électronique commun Cc relié à une pluralité de circuits locaux Cl-1, Cl-2 ... Cl-i ... Cl-n, adaptés pour que les signaux analogiques Sa-1, Sa-2 ... Sa-i ... Sa-n, qui sont respectivement délivrés aux circuits locaux Cl-1, Cl-2 ... Cl-i, soient convertis en des signaux numériques Sn-1, Sn-2 ... Sn-i ... Sn-n disponibles à des sorties de ces circuits locaux.

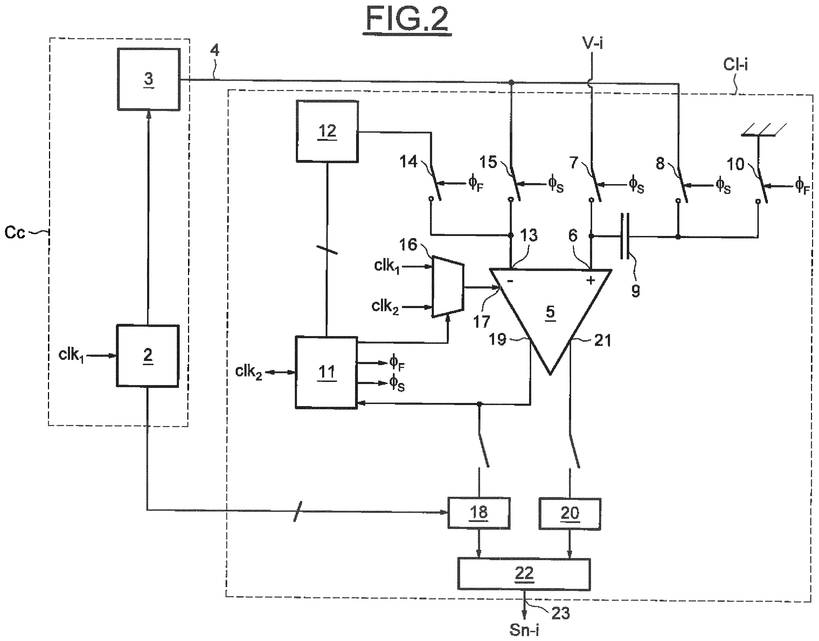

Comme illustré sur la figure 2, le circuit électronique commun Cc comprend un circuit de contrôle digital 2 soumis à un signal d'horloge clkl et apte à générer des premiers signaux numériques et un convertisseur 3 apte à convertir ces premiers signaux numériques en premiers signaux analogiques qui sont délivrés sur une ligne commune de connexion électrique 4.

Chaque circuit local Cl-i comprend un comparateur 5 dont une entrée 6 est reliée à la voie correspondante V-i par l'intermédiaire d'un interrupteur 7 et est reliée à la ligne commune 4 par l'intermédiaire d'un interrupteur 8 et d'un condensateur 9, le condensateur 9 étant placé entre l'entrée 6 et l'interrupteur 8.

La connexion commune entre l'interrupteur 8 et le condensateur 9 est reliée à la masse du dispositif par l'intermédiaire d'un interrupteur 10.

Chaque circuit local Cl-i comprend un séquenceur numérique 11 soumis à un signal d'horloge clk2 et relié à un convertisseur 12 apte à délivrer des seconds signaux analogiques à une autre entrée 13 du comparateur 5 par l'intermédiaire d'un interrupteur 14.

Cette autre entrée 13 est reliée à la ligne commune 4 par l'intermédiaire d'un interrupteur 15.

Le séquenceur numérique 11 présente une sortie reliée à une entrée de commande d'un circuit de sélection 16 qui reçoit les signaux d'horloge clkl et clk2 et dont la sortie est reliée à une entrée de commande 17 du comparateur 5.

Le séquenceur numérique 11 présente une sortie délivrant un signal de commande Φs des interrupteurs 7, 8 et 15 et une sortie délivrant un signal de commande Φf des interrupteurs 10 et 14.

Le séquenceur numérique 11 comprend en outre un registre de mémorisation 18 soumis à un signal d'ordre issu d'une sortie 19 du comparateur 5 et dont une entrée est reliée à une sortie du circuit de contrôle numérique 2.

Le séquenceur numérique 11 comprend en outre un registre de mémorisation 20 relié à une sortie 21 du comparateur 5.

Le séquenceur numérique 11 comprend également un circuit d'assemblage 22 relié aux registres de mémorisation 18 et 20 et présentant une sortie extérieure 23.

Le dispositif de conversion 1 peut fonctionner de la manière suivante.

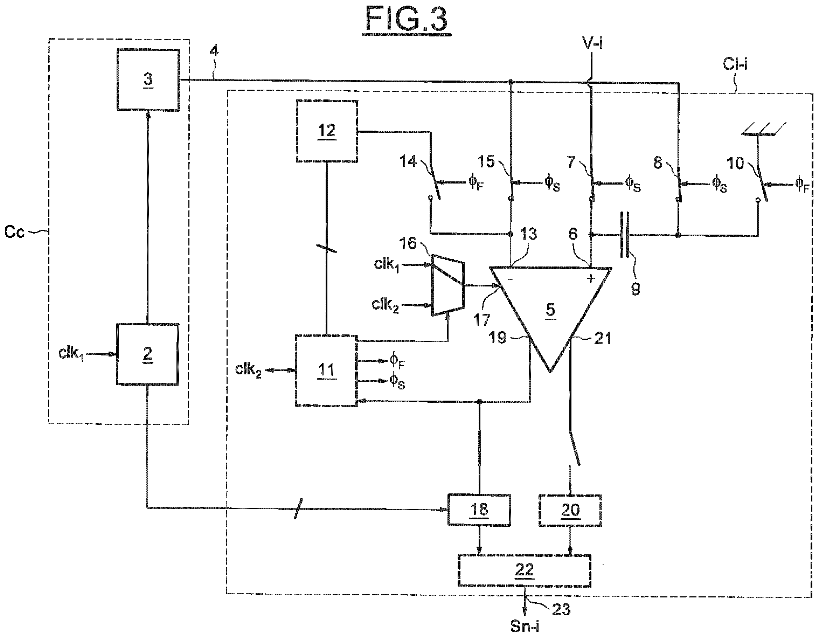

Pour l'exécution d'une première phase de conversion, le dispositif de conversion 1 est placé selon une configuration illustrée sur la figure 3.

Selon cette configuration, les interrupteurs 7, 8 et 15 de chaque circuit local Cl-i sont à l'état fermé de telle sorte que l'entrée 6 du comparateur 5 est reliée à la voie V-i correspondante et que l'entrée 13 du comparateur 5 est reliée à la ligne commune 4. Les interrupteurs 10 et 14 de chaque circuit local Cl-i sont à l'état ouvert. Le comparateur 5 est soumis à l'horloge clk1 au travers du circuit 16.

Sous l'effet d'une succession de signaux d'horloge clkl, le circuit de contrôle digital 2 génère une succession de premiers signaux codés prédéterminés. Chaque signal codé contient une pluralité d'états correspondants à des bits de poids forts m de signaux numériques prédéterminés.

La succession de signaux codés prédéterminés est convertie par le convertisseur 3 en une succession de premiers signaux analogiques délivrés par la ligne de connexion 4 à chacun des circuits locaux Cl-i. Ces premiers signaux analogiques présentent des valeurs en escalier formant une rampe ou une succession de paliers, à pas larges et réguliers ou irréguliers, ces valeurs étant successivement décroissantes. Les valeurs prédéterminées maximum et minimum de ces premiers signaux analogiques sont choisies de telle que les valeurs des signaux analogiques Sa-i à convertir soient incluses entre ces valeurs maximum et minimum.

Le fonctionnement de chaque circuit local Cl-i est alors le suivant.

Tant que les valeurs des paliers des signaux analogiques issues du convertisseur 3 sont supérieures à la valeur du signal Sa-i correspondant à convertir, la sortie 19 du comparateur 5 reste inchangée. Par contre, dès qu'un signal analogique issu du convertisseur 3 présente une valeur de palier inférieure à la valeur du signal analogique Sa-i, la sortie 19 du comparateur 5 change d'état.

Ce changement d'état du signal de sortie du comparateur 5 est transmis au registre de mémorisation 18 et induit l'enregistrement dans ce registre de mémorisation 18 du signal codé de bits de poids forts m issu du circuit de contrôle digital 2 et correspondant au signal analogique prédéterminé issu du convertisseur 3 et ayant provoqué ce changement d'état. Pour le circuit local Cl-i considéré, une première phase de conversion est terminée.

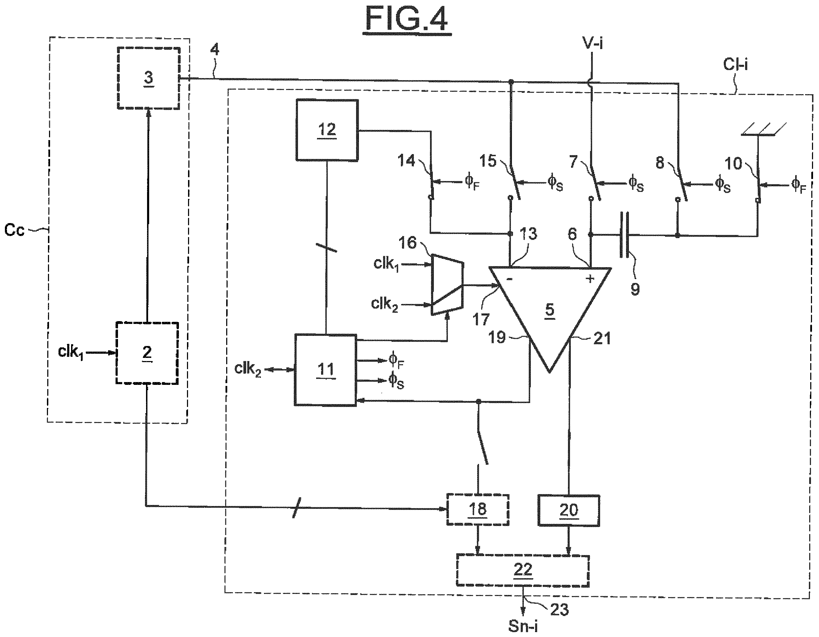

Le changement d'état du signal de sortie du comparateur 5 est également transmis au séquenceur numérique 11 qui place alors le circuit local Cl-i selon une seconde configuration illustrée sur la figure 4.

Le séquenceur 11 place les interrupteurs 7, 8 et 18 à l'état ouvert, isolant ainsi le circuit local Cl-i par rapport à la voie V-i et par rapport à la ligne commune 4. Ce faisant, la tension aux bornes de du condensateur 9 est égale à la différence entre la valeur du signal analogique de la voie V-i et de la valeur du signal analogique déterminé ayant provoqué ledit changement d'état, cette différence étant appelée « écart » ou « résidu ». Le condensateur constitue une mémoire de cet écart ou résidu dont la valeur est égale ou inférieure audit pas entre deux valeurs successives des signaux analogiques délivrés par le convertisseur 3 et est à ajouter à la valeur dudit signal analogique détecté ayant provoqué le changement d'état de la sortie du comparateur pour obtenir la valeur du signal analogique Sa-i à convertir.

Le séquenceur 11 place l'interrupteur 10 à l'état fermé pour relier le convertisseur 12 à l'entrée 13 du comparateur 5, place l'interrupteur 14 à l'état fermé pour relier la borne correspondante du condensateur 9 à l'entrée 8 du comparateur 5, et commande le circuit 16 pour que le comparateur 5 soit soumis au signal d'horloge clk2.

Commence alors, pour le circuit local Cl-i considéré, l'exécution d'une seconde phase de conversion réalisée spécifiquement par approximations successives de façon à convertir le résidu en des bits successifs de poids faibles n de signaux numériques. Une telle conversion par approximations successives est en particulier décrite dans les pages 143 et suivantes du manuel ayant pour titre « Principles of Data Conversion System Design », écrit par Behzad Razavi et édité par IEEE Press en 1995 et peut être réalisée par exemple comme décrit ci-dessous.

Dans le convertisseur 12 sont mémorisées une borne analogique supérieure et une borne analogique inférieure dont l'écart est supérieur au pas de la succession de pas précitée. Par exemple, cet écart inter-bornes peut être égal à deux pas.

Sous l'effet d'un premier signal d'horloge clk2, le séquenceur génère un signal codé converti par le convertisseur 12 en un signal analogique dont la valeur correspond à la moitié de l'écart inter-bornes ci-dessus.

Il peut se produire deux cas.

Selon un premier cas, si la valeur du signal analogique issu du convertisseur 12 est supérieure à la valeur du signal issu du condensateur 9, la sortie 21 du comparateur 5 ne change pas d'état.

Selon un second cas, si au contraire la valeur du signal analogique issu du convertisseur 12 est inférieure à la valeur du signal issu du condensateur 9, la sortie 21 du comparateur 5 change d'état.

Dans l'un ou l'autre cas, l'état de la sortie 21 du comparateur 5, qui constitue un premier bit de poids faible d'un signal numérique, est enregistré dans le registre de mémorisation 20.

Ensuite, sous l'effet d'un second signal d'horloge clk2, si le premier cas s'est produit, le séquenceur 11 génère un autre signal codé converti par le convertisseur 12 en un autre signal analogique dont la valeur correspond à la moitié de la moitié inférieure de l'écart inter-bornes ci-dessus. Si au contraire le second cas s'est produit, le séquenceur 11 génère un autre signal codé converti par le convertisseur 12 en un autre signal analogique dont la valeur correspond à la moitié de la moitié supérieure de l'écart inter-bornes ci-dessus.

Là également, il peut se produire deux cas.

Selon un premier cas, si l'autre signal analogique issu du convertisseur 12 est supérieur au signal issu du condensateur 9, la sortie 21 du comparateur 5 ne change pas d'état.

Selon un second cas, si au contraire l'autre signal analogique issu du convertisseur 12 est inférieur au signal issu du condensateur 9, la sortie 21 du comparateur 5 change d'état.

Dans l'un ou l'autre cas, l'état de la sortie 21 du comparateur 5, qui constitue un second bit de poids faible d'un signal numérique, est enregistré dans le registre de mémorisation 20.

Ensuite, à chaque signal d'horloge clk2 et de façon équivalente, le séquenceur génère un signal codé converti par le convertisseur 12 en un signal analogique dont la valeur est égale à la moitié inférieure ou supérieure de la moitié restante et l'état de la sortie 21 du comparateur 5, qui constitue à chaque fois un bit de poids faible d'un signal numérique, est enregistré dans le registre de mémorisation 20.

Les étapes ci-dessus sont renouvelées jusqu'à ce qu'un nombre prédéterminé d'états de la sortie du comparateur 5, égal au nombre de signaux d'horloge clk2 délivrés, soit enregistré dans le registre de mémorisation 20. Se trouve alors enregistré dans le registre de mémorisation 20 un signal codé d'un nombre n de bits de poids faibles d'un signal numérique, dont le nombre est égal au nombre de signaux d'horloge clk2 délivrés.

Ceci étant fait, le séquenceur 11 commande le circuit d'assemblage 22 de façon que ce dernier assemble les signaux codés de bits de poids forts m enregistrés dans le registre de mémorisation 18 et les signaux codés de bits de poids faibles n enregistrés dans le registre de mémorisation 20, de façon à délivrer sur la sortie 23 un signal numérique Sn-i correspondant à la conversion du signal analogique Sa-i.

Cet assemblage consiste à effectuer une concaténation par redondance desdits signaux codés de bits de poids forts et de bits de poids faibles. Le signal numérique obtenu comprend les bits de poids faibles, à l'exception du plus grand, et les bits de poids forts auxquels est additionné le plus grand des bits de poids faibles, en additionnant le plus grand des bits de poids faibles et le plus petit des bits de poids forts et en reportant le reste éventuel sur le bits suivant de poids forts et ainsi de suite. Il en résulte que le nombre de bits du signal numérique obtenu est égal au nombre de bits de poids forts m plus le nombre de bits de poids faibles n moins un.

Après quoi, le séquenceur replace les interrupteurs 7, 8, 10, 14 et 15 dans leur état initial tel que décrit en référence à la figure 3.

La totalité de la succession de premiers signaux analogiques prédéterminés, issus du convertisseur 3 du circuit commun Cc, ayant été délivrée et les circuits locaux Cl-i ayant respectivement réalisés la conversion du signal analogique Sa-i correspondant en un signal numérique Sn-i, un nouveau cycle de conversion peut commencer.

Le dispositif de conversion 1 et le procédé de fonctionnement qui lui est associé présentent les avantages suivants.

La durée totale minimum pour la réalisation d'un cycle de conversion est égale ou légèrement supérieure à l'addition de la durée nécessaire pour générer la totalité de la succession ou rampe des premiers signaux analogiques prédéterminés issus du convertisseur 3 du circuit commun Cc, de la durée nécessaire, par un circuit local Cc-i, pour la détection et la mémorisation du signal codé de bits de poids forts dans le registre de mémorisation 18, de la durée de détection par approximations successives, par un circuit local Cc-i, et de mémorisation du signal codé de bits de poids faibles et de la durée de l'assemblage des bits de poids forts et des bits de poids faibles par le circuit d'assemblage 22. Cette durée totale peut être très réduite, eu égard au nombre de bits des signaux codés Sn-i délivrés qui peut être accru.

Compte tenu en particulier de l'existence d'une ligne commune 4 reliant le circuit commun Cc aux circuits locaux Cl-i incluant chacun un comparateur unique 5, la surface occupée par les circuits peut être réduite et la consommation peut en conséquence être réduite. L'existence d'un comparateur unique 5 dans chaque circuit local Cl-i permet de limiter les conséquences liées aux déperditions d'offsets entre les deux phases de conversion. En outre, l'assemblage par redondance des bits de poids forts et des bits de poids faibles permet de compenser au moins en partie les éventuelles imperfections du comparateur 5 et les éventuelles irrégularités des pas de la succession précitée de pas.

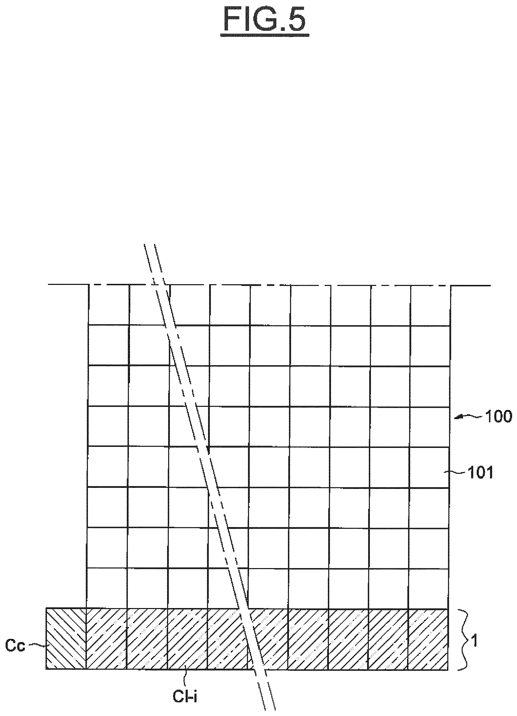

Sur la figure 5 est illustrée une matrice 100 qui comprend une pluralité de capteurs 101 disposés les uns à côté des autres sur des lignes et des colonnes. Sur un côté de cette matrice 100 est aménagé un dispositif de conversion 1 dont les circuits locaux Cl-i occupent la largeur des colonnes correspondantes et sont disposés sur une ligne à l'extrémité de laquelle est placé le circuit commun Cc.

Dans la description qui précède, il est considéré que les paliers des valeurs en escalier des premiers signaux analogiques sont décroissants. Selon une variante de réalisation, ces valeurs pourraient être successivement croissantes. Dans ce cas, le changement d'état du comparateur 5 se produit au passage d'une valeur de palier supérieure à la valeur du signal analogique à convertir. Le résidu stocké dans la capacité 9 est alors le complément du résidu précité par rapport à l'écart ou pas entre les valeurs de paliers.

Selon un exemple de réalisation, un amplificateur pourrait être intercalé entre la capacité 9 et l'entrée 6 du comparateur 5 de façon à amplifier la valeur du résidu stocké dans la capacité 9 de façon à améliorer l'immunité au bruit et faciliter la production des signaux issus du convertisseur 12.

La présente invention ne se limite pas aux exemples ci-dessus décrits. Bien d'autres variantes de réalisation sont possibles, sans sortir du cadre de l'invention.

## Revendications

1. Procédé de conversion de signaux analogiques, présents respectivement sur une pluralité de voies, en des signaux numériques, comprenant :
générer sur une ligne commune (4), par un circuit générateur commun (2, 3) comprenant un circuit de contrôle digital (2) soumis à un signal d'horloge clk1, une succession, commune à toutes les voies, de premiers signaux analogiques prédéterminés présentant des valeurs prédéterminées en escalier à pas successifs larges, formant une rampe ou succession de paliers évoluant de façon monotone, dont chaque valeur correspond à des bits de poids forts de signaux numériques,
et, pour chaque voie,
chaque voie comprenant un circuit local Cl-i comprenant un comparateur (5), un premier moyen de mémorisation (18) de bits de poids forts de signaux numériques, un moyen de mémorisation (9) d'un écart ou résidu, un moyen générateur (11, 12) apte à générer un nombre prédéterminé de seconds signaux analogiques et des signaux de commande d'interrupteurs, un second moyen de mémorisation (20) de bits de poids faibles de signaux numériques, et un moyen d'assemblage (22) pour assembler des bits de poids forts et des bits de poids faibles,
- dans une première phase :
comparer, par le comparateur (5), la valeur du signal analogique à convertir successivement à chacune desdites valeurs prédéterminées de ladite rampe,
détecter la première valeur prédéterminée de ladite rampe, issue de la comparaison ci-dessus, succédant à la valeur du signal analogique à convertir,
mémoriser, par le premier moyen de mémorisation (18), les valeurs des bits de poids forts correspondant à ladite première valeur prédéterminée détectée,
mémoriser, par le moyen de mémorisation (9) d'un écart ou résidu, l'écart ou résidu résultant de la différence entre la valeur du signal analogique à convertir et ladite valeur prédéterminée détectée,
- dans une deuxième phase :
comparer, par le comparateur (5), par approximations successives ledit écart ou résidu aux seconds signaux analogiques prédéterminés par le moyen générateur (11, 12), les seconds signaux analogiques prédéterminés étant compris entre deux bornes de seconds signaux analogiques dont l'écart inter-bornes est supérieur audit pas de ladite rampe,
mémoriser, par le second moyen de mémorisation (20), successivement les états des résultats de la comparaison par approximations successives, correspondant à des bits de poids faibles de signaux numériques,
- dans une troisième phase :
assembler, par le moyen d'assemblage, les bits de poids forts et les bits de poids faibles, de façon à délivrer un signal numérique correspondant à la valeur du signal analogique à convertir, ce signal numérique comprenant les bits de poids faibles, à l'exception du plus grand, et les bits de poids forts auxquels est additionné le plus grand des bits de poids faibles, en additionnant le plus grand des bits de poids faibles et le plus petit des bits de poids forts, si bien que le nombre de bits du signal numérique obtenu est égal au nombre de bits de poids forts plus le nombre de bits de poids faibles moins un,
pour chaque voie :
le comparateur (5) présentant une entrée (6) reliée à la voie correspondante V-i par l'intermédiaire d'un interrupteur 7 et reliée à la ligne commune (4) par l'intermédiaire d'un interrupteur 8 et d'un condensateur (9), en tant que moyen de mémorisation (9) de l'écart ou résidu, le condensateur (9) étant placé entre l'entrée (6) et l'interrupteur 8, la connexion commune entre l'interrupteur 8 et le condensateur (9) étant reliée à la masse par l'intermédiaire d'un interrupteur 10,
chaque moyen générateur (11, 12) comprenant un séquenceur numérique (11) et un convertisseur (12), le séquenceur numérique (11) étant soumis à un signal d'horloge clk2 et étant relié au convertisseur (12) apte à délivrer les seconds signaux analogiques à une autre entrée (13) du comparateur (5) par l'intermédiaire d'un interrupteur 14, cette autre entrée (13) étant reliée à la ligne commune (4) par l'intermédiaire d'un interrupteur 15, et
chaque séquenceur numérique (11) présentant une sortie reliée à une entrée de commande d'un circuit de sélection (16) qui reçoit les signaux d'horloge clkl et clk2 et dont la sortie est reliée à une entrée de commande (17) du comparateur (5),
pour l'exécution de la première phase de conversion, les interrupteurs 7, 8 et 15 de chaque circuit local Cl-i étant à l'état fermé de telle sorte que l'entrée (6) du comparateur (5) est reliée à la voie V-i correspondante et que l'entrée (13) du comparateur (5) est reliée à la ligne commune (4), les interrupteurs 10 et 14 de chaque circuit local Cl-i étant à l'état ouvert, le comparateur (5) étant soumis à l'horloge clkl au travers du circuit de sélection (16), puis
suite à la mémorisation, par le premier moyen de mémorisation (18), des valeurs des bits de poids forts, le séquenceur numérique (11) place les interrupteurs 7, 8 et 18 à l'état ouvert, isolant ainsi le circuit local Cl-i par rapport à la voie V-i et par rapport à la ligne commune (4), et place l'interrupteur 10 à l'état fermé pour relier le convertisseur (12) à l'entrée (13) du comparateur (5), place l'interrupteur 14 à l'état fermé pour relier la borne correspondante du condensateur (9) à l'entrée (8) du comparateur (5), et commande le circuit de sélection (16) pour que le comparateur (5) soit soumis au signal d'horloge clk2, de sorte que la deuxième phase de conversion commence.

2. Procédé selon la revendication 1, comprenant :
comparer la valeur du signal analogique à convertir successivement à chacune desdites valeurs prédéterminées, dans le sens décroissant,
détecter la première valeur prédéterminée du premier signal analogique inférieure à la valeur du signal analogique à convertir.

3. Dispositif de conversion de signaux analogiques, présents respectivement sur une pluralité de voies, en des signaux numériques, pour la mise en œuvre du procédé selon l'une des revendications 1 et 2, comprenant :
un circuit générateur commun (2, 3) apte à générer une succession de premiers signaux analogiques prédéterminés présentant des premières valeurs prédéterminées correspondant à des bits de poids forts de signaux numériques et comprenant un circuit de contrôle digital (2) soumis à un signal d'horloge clkl,
et, pour chaque voie, un circuit local comprenant :
un premier moyen de comparaison, incluant un comparateur unique (5), pour comparer lesdits premiers signaux analogiques prédéterminés avec le signal analogique à convertir,
un premier moyen de mémorisation (18) des bits de poids forts de signaux numériques correspondant à la valeur du premier signal analogique prédéterminé succédant à la valeur du signal analogique correspondant à convertir et détectée par ledit premier moyen de comparaison,
un moyen de mémorisation (9) de l'écart ou résidu résultant de la différence entre la valeur du signal analogique correspondant à convertir et ladite première valeur prédéterminée détectée,
un moyen générateur (11, 12) apte à générer un nombre prédéterminé de seconds signaux analogiques,
un second moyen de comparaison, incluant ledit comparateur unique (5), pour comparer par approximations successives lesdits seconds signaux analogiques avec respectivement ledit écart ou résidu,
un second moyen de mémorisation (20) des bits de poids faibles de signaux numériques correspondant aux résultats issus dudit second moyen de comparaison,
et un moyen d'assemblage pour assembler lesdits bits de poids forts et lesdits bits de poids faibles, de façon à délivrer un signal numérique correspondant au signal analogique correspondant à convertir,
le comparateur (5) présentant une entrée (6) reliée à la voie correspondante V-i par l'intermédiaire d'un interrupteur 7 et reliée à la ligne commune (4) par l'intermédiaire d'un interrupteur 8 et d'un condensateur (9), en tant que moyen de mémorisation (9) de l'écart ou résidu, le condensateur (9) étant placé entre l'entrée (6) et l'interrupteur 8, la connexion commune entre l'interrupteur 8 et le condensateur (9) étant reliée à la masse par l'intermédiaire d'un interrupteur 10,
chaque moyen générateur (11, 12) comprenant un séquenceur numérique (11) et un convertisseur (12), le séquenceur numérique (11) étant soumis à un signal d'horloge clk2 et étant relié au convertisseur (12) apte à délivrer les seconds signaux analogiques à une autre entrée (13) du comparateur (5) par l'intermédiaire d'un interrupteur 14, cette autre entrée (13) étant reliée à la ligne commune (4) par l'intermédiaire d'un interrupteur 15, et
chaque séquenceur numérique (11) présentant une sortie reliée à une entrée de commande d'un circuit de sélection (16) qui reçoit les signaux d'horloge clkl et clk2 et dont la sortie est reliée à une entrée de commande (17) du comparateur (5).

4. Matrice de capteurs équipée d'un dispositif de conversion selon la revendication 3, les circuits locaux étant placés aux extrémités des colonnes de cette matrice, sur une ligne à l'extrémité de laquelle est placé le circuit commun.

## Patentansprüche

1. Verfahren zum Umwandeln von analogen Signalen, die jeweils auf einer Vielzahl von Kanälen anliegen, in digitale Signale, umfassend:
Erzeugen, auf einer gemeinsamen Leitung (4) durch eine gemeinsame Erzeugungsschaltung (2, 3), die eine digitale Steuerschaltung (2) umfasst, welche einem Taktsignal clk1 unterliegt, einer für alle die Kanäle gemeinsamen Folge von vorbestimmten ersten analogen Signalen, die vorbestimmte Werte in Treppenform mit zunehmend großen Schrittweiten aufweisen, die eine Rampe oder sich monoton entwickelnde Stufenfolge bilden, von der jeder Wert Bits mit hohen Wertigkeiten von digitalen Signalen entspricht,
und, für jeden Kanal,
wobei jeder Kanal eine lokale Schaltung Cl-i umfasst, die einen Vergleicher (5), ein erstes Mittel zum Speichern (18) von Bits mit hohen Wertigkeiten von digitalen Signalen, ein Mittel zum Speichern (9) eines Abstands oder Rests, ein Erzeugungsmittel (11, 12), das in der Lage ist, eine vorbestimmte Anzahl von zweiten analogen Signalen und Schaltersteuersignale zu erzeugen, ein zweites Mittel zum Speichern (20) von Bits mit niedrigen Wertigkeiten von digitalen Signalen, und ein Assemblierungsmittel (22) zum Assemblieren der Bits mit hohen Wertigkeiten und der Bits mit niedrigen Wertigkeiten umfasst,
- in einer ersten Phase:
Vergleichen des Werts des analogen Signals, das umgewandelt werden soll, durch den Vergleicher (5) nacheinander mit jedem der vorbestimmten Werte der Rampe,
Erkennen des ersten vorbestimmten Werts der Rampe, der aus dem obigen Vergleich hervorgeht, der auf den Wert des umzuwandelnden analogen Signals folgt,
Speichern der Werte der Bits mit hohen Wertigkeiten, die dem erkannten ersten vorbestimmten Wert entsprechen, durch das Speichermittel (18),
Speichern eines Abstands oder Rests durch das Speichermittel (9), wobei sich der Abstand oder Rest aus der Differenz zwischen dem Wert des umzuwandelnden analogen Signals und dem erkannten vorbestimmten Wert ergibt,
- in einer zweiten Phase:
Vergleichen des Abstands oder Rests mit den vom Erzeugungsmittel (11, 12) vorbestimmten zweiten analogen Signalen durch den Vergleicher (5) durch sukzessive Annäherungen, wobei die vorbestimmten zweiten analogen Signale zwischen zwei Grenzen von zweiten analogen Signalen liegen, deren Abstand zwischen den Grenzen größer ist als die Schrittweite der Rampe,
sukzessives Speichern der Zustände der Ergebnisse des Vergleichs durch sukzessive Annäherungen, die Bits mit niedrigen Wertigkeiten von digitalen Signalen entsprechen, durch das zweite Speichermittel (20),
- in einer dritten Phase:
Assemblieren der Bits mit hohen Wertigkeiten und der Bits mit niedrigen Wertigkeiten durch das Assemblierungsmittel, um ein digitales Signal zu liefern, das dem Wert des umzuwandelnden analogen Signals entspricht, wobei dieses digitale Signal die Bits mit niedrigen Wertigkeiten, mit Ausnahme des größten, und die Bits mit hohen Wertigkeiten umfasst, zu denen das größte der Bits mit niedrigen Wertigkeiten addiert wird, indem das größte der Bits mit niedrigen Wertigkeiten und das kleinste der Bits mit hohen Wertigkeiten addiert werden, sodass die Bitzahl des erhaltenen digitalen Signals gleich der Anzahl von Bits mit hohen Wertigkeiten plus der Anzahl von Bits mit niedrigen Wertigkeiten minus eins ist,
wobei, für jeden Kanal:
der Vergleicher (5) einen Eingang (6) aufweist, der mittels eines Schalters 7 an den entsprechenden Kanal V-i angeschlossen ist, und mittels eines Schalters 8 und eines Kondensators (9) als Mittel zum Speichern (9) des Abstands oder Rests an die gemeinsame Leitung (4) angeschlossen ist, wobei der Kondensator (9) zwischen dem Eingang (6) und dem Schalter 8 angeordnet ist, wobei die gemeinsame Verbindung zwischen dem Schalter 8 und dem Kondensator (9) mittels eines Schalters 10 an die Masse angeschlossen ist,
jedes Erzeugungsmittel (11, 12) eine digitale Ablaufsteuerung (11) und einen Wandler (12) umfasst, wobei die digitale Ablaufsteuerung (11) einem Taktsignal clk2 unterliegt und mittels eines Schalters 14 an den Wandler (12) angeschlossen ist, der in der Lage ist, die zweiten analogen Signale an einen anderen Eingang (13) des Vergleichers (5) zu liefern, wobei dieser andere Eingang (13) mittels eines Schalters 15 an die gemeinsame Leitung (4) angeschlossen ist, und
jede digitale Ablaufsteuerung (11) einen Ausgang aufweist, der an einen Steuereingang einer Auswahlschaltung (16) angeschlossen ist, die die Taktsignale clk1 und clk2 empfängt und deren Ausgang an einen Steuereingang (17) des Vergleichers (5) angeschlossen ist,
wobei sich zum Ausführen der ersten Umwandlungsphase die Schalter 7, 8 und 15 jeder lokalen Schaltung Cl-i im geschlossenen Zustand befinden, sodass der Eingang (6) des Vergleichers (5) an den entsprechenden Kanal V-i angeschlossen ist, und dass der Eingang (13) des Vergleichers (5) an die gemeinsame Leitung (4) angeschlossen ist, wobei sich die Schalter 10 und 14 jeder lokalen Schaltung Cl-i im offenen Zustand befinden, wobei der Vergleicher (5) durch die Auswahlschaltung (16) dem Takt clk1 unterliegt, und anschließend
im Anschluss an das Speichern der Werte der Bits mit hohen Wertigkeiten durch das erste Speichermittel (18) die digitale Ablaufsteuerung (11) die Schalter 7, 8 und 18 in den offenen Zustand setzt, wodurch er die lokale Schaltung Cl-i in Bezug auf den Kanal V-i und in Bezug auf die gemeinsame Leitung (4) trennt, und den Schalter 10 in den geschlossenen Zustand setzt, um den Wandler (12) an den Eingang (13) des Vergleichers (5) anzuschließen, den Schalter 14 in den geschlossenen Zustand setzt, um die entsprechende Klemme des Kondensators (9) an den Eingang (8) des Vergleichers (5) anzuschließen, und die Auswahlschaltung (16) so steuert, dass der Vergleicher (5) dem Taktsignal clk2 unterliegt, sodass die zweite Umwandlungsphase beginnt.

2. Verfahren nach Anspruch 1, umfassend:
sukzessives Vergleichen des Werts des umzuwandelnden analogen Signals mit jedem der vorbestimmten Werte in der absteigenden Richtung,
Erkennen des ersten vorbestimmten Werts des ersten analogen Signals, der kleiner ist als der Wert des umzuwandelnden analogen Signals.

3. Vorrichtung zum Umwandeln von analogen Signalen, die jeweils auf einer Vielzahl von Kanälen anliegen, in digitale Signale, zum Implementieren des Verfahrens nach einem der Ansprüche 1 und 2, umfassend:
eine gemeinsame Erzeugungsschaltung (2, 3), die in der Lage ist, eine Folge von vorbestimmten ersten analogen Signalen zu erzeugen, die vorbestimmte erste Werte aufweisen, welche Bits mit hohen Wertigkeiten von digitalen Signalen entsprechen, und eine digitale Steuerschaltung (2) umfasst, die einem Taktsignal clk1 unterliegt,
und, für jeden Kanal eine lokale Schaltung, umfassend:
ein erstes Vergleichsmittel, das einen einzigen Vergleicher (5) einschließt, um die vorbestimmten ersten analogen Signale mit dem umzuwandelnden analogen Signal zu vergleichen,
ein erstes Mittel zum Speichern (18) der Bits mit hohen Wertigkeiten von digitalen Signalen, die dem Wert des vorbestimmten ersten analogen Signals entsprechen, der dem Wert des entsprechenden umzuwandelnden analogen Signals folgt und von dem ersten Vergleichsmittel erkannt wird,
ein Mittel zum Speichern (9) des Abstands oder Rests, der sich aus der Differenz zwischen dem Wert des entsprechenden umzuwandelnden analogen Signals und dem erkannten ersten vorbestimmten Wert ergibt,
ein Erzeugungsmittel (11, 12), das in der Lage ist, eine vorbestimmte Anzahl von zweiten analogen Signalen zu erzeugen,
ein zweites Vergleichsmittel, das den einzigen Vergleicher (5) einschließt, um die zweiten analogen Signale durch sukzessive Annäherungen mit dem Abstand beziehungsweise Rest zu vergleichen,
ein zweites Mittel zum Speichern (20) der Bits mit niedrigen Wertigkeiten von digitalen Signalen, die den aus dem zweiten Vergleichsmittel stammenden Ergebnissen entsprechen,
und ein Assemblierungsmittel, um die Bits mit hohen Wertigkeiten und die Bits mit niedrigen Wertigkeiten zu assemblieren, um ein digitales Signal zu liefern, das dem entsprechenden umzuwandelnden analogen Signal entspricht,
wobei der Vergleicher (5) einen Eingang (6) aufweist, der mittels eines Schalters 7 an den entsprechenden Kanal V-i angeschlossen ist, und mittels eines Schalters 8 und eines Kondensators (9) als Mittel zum Speichern (9) des Abstands oder Rests an die gemeinsame Leitung (4) angeschlossen ist, wobei der Kondensator (9) zwischen dem Eingang (6) und dem Schalter 8 angeordnet ist, wobei die gemeinsame Verbindung zwischen dem Schalter 8 und dem Kondensator (9) mittels eines Schalters 10 an die Masse angeschlossen ist,
wobei jedes Erzeugungsmittel (11, 12) eine digitale Ablaufsteuerung (11) und einen Wandler (12) umfasst, wobei die digitale Ablaufsteuerung (11) einem Taktsignal clk2 unterliegt und mittels eines Schalters 14 an den Wandler (12) angeschlossen ist, der in der Lage ist, die zweiten analogen Signale an einen anderen Eingang (13) des Vergleichers (5) zu liefern, wobei dieser andere Eingang (13) mittels eines Schalters 15 an die gemeinsame Leitung (4) angeschlossen ist, und
wobei jede digitale Ablaufsteuerung (11) einen Ausgang aufweist, der an einen Steuereingang einer Auswahlschaltung (16) angeschlossen ist, die die Taktsignale clk1 und clk2 empfängt und deren Ausgang an einen Steuereingang (17) des Vergleichers (5) angeschlossen ist.

4. Sensormatrix, die mit einer Umwandlungsvorrichtung nach Anspruch 3 ausgestattet ist, wobei die lokalen Schaltungen an den Enden der Spalten dieser Matrix angeordnet sind, an einer Leitung, an deren Ende die gemeinsame Schaltung angeordnet ist.

## Claims

1. Method for converting analog signals, present respectively on a plurality of channels, into digital signals, comprising:
Generating, on a common line (4), by a common generator circuit (2, 3) comprising a digital control circuit (2) subjected to a clock signal clk1, a succession, common to all the channels, of predetermined first analog signals having predetermined values in a staircase-like sequence with wide successive steps, forming a ramp or succession of levels changing monotonically, each value of which corresponds to most significant bits of digital signals,
and, for each channel,
each channel comprising a local circuit Cl-i comprising a comparator (5), a first means (18) for storing most significant bits of digital signals, a means (9) for storing a difference or remainder, a generator means (11, 12) able to generate a predetermined number of second analog signals and switch-control signals, a second means (20) for storing least significant bits of digital signals, and an assembly means (22) for assembling most significant bits and least significant bits,
- in a first phase:
comparing, by means of the comparator (5), the value of the analog signal to be converted successively at each of said predetermined values of said ramp,
detecting the predetermined first value of said ramp, resulting from the above comparison, following the value of the analog signal to be converted, storing, by means of the first storage means (18), the values of the most significant bits corresponding to said predetermined first value detected,
storing, by means of the means (9) for storing a difference or remainder, the difference or remainder resulting from the difference between the value of the analog signal to be converted and said predetermined value detected,
- in a second phase:
comparing, by means of the comparator (5), by successive approximations, said difference or remainder with the second analog signals predetermined by the generator means (11, 12), the predetermined second analog signals lying between two bounds of second analog signals the inter-bound difference of which is greater than said step of said ramp,
storing, by means of the second storage means (20), successively the states of the results of the comparison by successive approximations, corresponding to least significant bits of digital signals,
- in a third phase:
assembling, by means of the assembly means, the most significant bits and the least significant bits, so as to deliver a digital signal corresponding to the value of the analog signal to be converted, this digital signal comprising the least significant bits, with the exception of the largest, and the most significant bits to which there is added the largest of the least significant bits, adding the largest of the least significant bits and the smallest of the most significant bits, so that the number of bits of the digital signal obtained is equal to the number of most significant bits plus the number of least significant bits minus one,
for each channel:
the comparator (5) having an input (6) connected to the corresponding channel V-i by means of a switch 7 and connected to the common line (4) by means of a switch 8 and a capacitor (9), as a means (9) for storing the difference or remainder, the capacitor (9) being placed between the input (6) and the switch 8, the common connection between the switch 8 and the capacitor (9) being connected to earth by means of a switch 10,
each generator means (11, 12) comprising a digital sequencer (11) and a converter (12), the digital sequencer (11) being subjected to a clock signal clk2 and being connected to the converter (12) able to deliver the second analog signals to another input (13) of the comparator (5) by means of a switch 14, this other input (13) being connected to the common line (4) by means of a switch 15, and
each digital sequencer (11) having an output connected to a control input of a selection circuit (16) that receives the clock signals clk1 and clk2 and the output of which is connected to a control input (17) of the comparator (5)
for executing the first conversion phase, the switches 7, 8 and 15 of each local circuit Cl-i being in the closed state so that the input (6) of the comparator (5) is connected to the corresponding channel V-i and so that the input (13) of the comparator (5) is connected to the common line (4), the switches 10 and 14 of each local circuit Cl-i being in the open state, the comparator (5) being subjected to the clock clk1 through the selection circuit (16), and then
following the storage, by the first storage means (18), of the values of the most significant bits, the digital sequencer (11) places the switches 7, 8 and 18 in the open state, thus isolating the local circuit Cl-i with respect to the channel V-i and with respect to the common line (4), and places the switch 10 in the closed state in order to connect the converter (12) to the input (13) of the comparator (5), places the switch 14 in the closed state in order to connect the corresponding terminal of the capacitor (9) to the input (8) of the comparator (5), and controls the selection circuit (16) so that the comparator (5) is subjected to the clock signal clk2, so that the second conversion phase commences.

2. Method according to claim 1, comprising:
comparing the value of the analog signal to be converted successively with each of said predetermined values, in the decreasing direction,
detecting the predetermined first value of the first analog signal lower than the value of the analog signal to be converted.

3. Device for converting analog signals, present respectively on a plurality of channels, into digital signals, for implementing the method according to either of claims 1 and 2, comprising:
a common generator circuit (2, 3) able to generate a succession of predetermined first analog signals having predetermined first values corresponding to most significant bits of digital signals and comprising a digital control circuit (2) subjected to a clock signal clk1,
and, for each channel, a local circuit comprising:
a first comparison means, including a single comparator (5), for comparing said predetermined first analog signals with the analog signal to be converted,
a first means (18) for storing the most significant bits of digital signals corresponding to the value of the predetermined first analog signal succeeding the value of the corresponding analog signal to be converted and detected by said first comparison means,
a means (9) for storing the difference or remainder resulting from the difference between the value of the corresponding analog signal to be converted and said predetermined first value detected,
a generator means (11, 12) able to generate a predetermined number of second analog signals,
a second comparison means, including said single comparator (5), for comparing, by successive approximations, said second analog signals with respectively said difference or remainder,
a second means (20) for storing the least significant bits of digital signals corresponding to the results issuing from said second comparison means,
and an assembly means for assembling said most significant bits and said least significant bits, so as to deliver a digital signal corresponding to the corresponding analog signal to be converted,
the comparator (5) having an input (6) connected to the corresponding channel V-i by means of a switch 7 connected to the common line (4) by means of a switch 8 and a capacitor (9), as a means (9) for storing the difference or remainder, the capacitor (9) being placed between the input (6) and the switch 8, the common connection between the switch 8 and the capacitor (9) being connected to earth by means of a switch 10, each generator means (11, 12) comprising a digital sequencer (11) and a converter (12), the digital sequencer (11) being subjected to a clock signal clk2 and being connected to the converter (12) able to deliver the second analog signals to another input (13) of the comparator (5) by means of a switch 14, this other input (13) being connected to the common line (4) by means of a switch 15, and
each digital sequencer (11) having an output connected to a control input of a selection circuit (16) that receives the clock signals clk1 and clk2 and the output of which is connected to a control input (17) of the comparator (5).

4. Matrix of sensors equipped with a conversion device according to claim 3, the local circuits being placed at the ends of the columns of this matrix, on a line at the end of which the common circuit is placed.
